**Europäisches Patentamt**

**European Patent Office**

**Office européen des brevets**

(11) Numéro de publication: **0 000 676**
**B1**

(12) **FASCICULE DE BREVET EUROPEEN**

(21) Numéro de dépôt: **78400057.2**

(22) Date de dépôt: **11.07.78**

(51) Int. Cl.³: **H 01 J 37/24, B 23 K 15/00**

(54) **Procédé et installation de régulation d'un générateur de soudage par faisceau d'électrons**

(30) Priorité: **22.07.77 FR 7722599**

(43) Date de publication de la demande:
**07.02.79 Bulletin 79/03**

(45) Mention de la délivrance du brevet:
**07.01.81 Bulletin 81/01**

(84) Etats contractants désignés:
**BE DE FR GB**

(56) Documents cités:
AUTOMATIC WELDING, vol. 22, n° 2,
février 1969, Cambridge, GB
O. K. NAZARENKO et al. "A new 13.5 kW electron
beam welding apparatus" pages 58—62

WELDING AND METAL FABRICATION, vol. 46,
n°2, mars 1978, Haywards Heath, GB
F. CORCELLE et al. "High power electron beam
welding gun mobile in low vacuum", pages 75,
77, 78, 81—84.

(73) Titulaire: **LA SOUDURE AUTOGENE
FRANCAISE**
**75, Quai d'Orsay**
**F - 75321 Paris Cedex 07 (FR)**
**COMMISSARIAT A L'ENERGIE ATOMIQUE**
**Etablissement de Caractère Scientifique**
**Technique et Industriel B.P. 510**
**F - 75752 Paris Cedex 15 (FR)**

(72) Inventeur: **Corcelle, François**
**Les Morènes**
**F - 01710 Thoiry (FR)**
**Hamon, Jean-Pierre**
**12, rue des Maradas Verts**
**F - 95000 Cergy (FR)**
**Martin, Philippe**
**Résidence des Essarts 26, rue de Chartres**
**F - 91400 Orsay (FR)**

(74) Mandataire: **Bouton Neuvy, Liliane, et al**
**L'Air liquide, Société Anonyme pour L'Etude
et L'Exploitation des Procédés Georges Claude 75,
Quai d'Orsay**
**F - 75321 Paris Cedex 07 (FR)**

Courier Press, Leamington Spa, England.

# Procédé et installation de régulation d'un générateur de soudage par faisceau d'électrons

L'invention concerne un procédé et une installation de régulation d'un générateur de soudage par faisceau d'électrons.

Dans certains cas de soudage par faisceau d'électrons, en particulier lors du soudage de pièces circulaires, il s'avère nécessaire, afin d'éliminer les défauts qu'occasionnent les montées en puissance et les extinctions brutales, d'effectuer une montée progressive en puissance suivie d'un palier en puissance substantiellement constante (ou variable selon la configuration de la pièce) puis une descente progressive en puissance à la fin de l'opération de soudage.

Dans le cas de machine de production à grande cadence, ou dans le cas de production de pièces délicates à souder, il s'est avéré nécessaire, pour obtenir un taux de rebut minimal, de réguler à des valeurs aussi constantes que possible les paramètres essentiels du soudage, à savoir la haute tension d'accélération, le courant de soudage débité par le canon et le courant de la lentille magnétique de focalisation.

Cette régulation de la puissance de soudage est généralement effectuée par l'un ou l'autre des deux procédés suivants:

—d'une part, on peut faire varier seulement la valeur de la haute tension, ce qui entraîne une variation corrélative du courant de soudage, donc de la puissance délivrée par le canon électronique. C'est le fonctionnement dit en régime "diode",

—d'autre part, on peut faire varier seulement le courant électronique de soudage émis par le canon en maintenant la haute tension constante et cela en polarisant plus ou moins négativement le Wehnelt par rapport à la cathode. C'est le fonctionnement en régime "triode". Ce mode de régulation est par exemple connu de l'article publié dans le journal "automatic Welding", volume 22, 1969, n° 2 pages 58 à 62, où l'on décrit un procédé et un dispositif de régulation d'un générateur de soudage par faisceau d'électrons du genre comportant un canon électronique à trois électrodes : cathode, Wehnelt, anode, selon lequel on agit sur la tension d'accélération entre cathode et anode et/ou sur la tension de polarisation du Wehnelt, pour assurer une opération de soudage comprenant une phase initiale de montée progressive en puissance, une phase opératoire substantiellement en palier de puissance qui est assurée par un maintien substantiellement constant de la tension d'accélération tout en régulant dans d'étroites limites, la puissance par variation du courant de soudage obtenue exclusivement par variation du potentiel du Wehnelt et une phase terminale de descente progressive en puissance.

L'une et l'autre de ces procédés ont leurs avantages et inconvénients respectifs.

L'avantage principal du fonctionnement en régime "diode" réside dans le fait que le point de concentration électrostatique ou "crossover" du faisceau électronique reste sensiblement inchangé au cours du réglage et en le situant au niveau du passage de traversée d'anode, on peut réaliser ce passage de façon aussi étroite que possible, ce qui permet d'accroître considérablement la perte de charge entre l'espace interélectrodes et le reste du canon, permettant ainsi de maintenir un vide profond de l'order de $1,33 \cdot 10^{-5}$ mbar ($10^{-5}$ torr) dans cet espace inter-électrode qui est particulièrement délicat du fait des risques de claquages, tandis que le reste du canon électronique, c'est-à-dire la zone de la lentille électromagnétique et même la chambre de soudage peuvent être maintenues sous un vide moins profond dit vide primaire, de l'ordre de $1,33 \cdot 10^{-2}$ à $1,33 \cdot 10^{-3}$ mbar ($10^{-2}$ à $10^{-3}$ torr).

L'inconvénient principal de fonctionnement en régime "diode" est que la puissance peut varier substantiellement en fonction non seulement de variations de la haute tension, mais également en fonction de la pervéance du canon, cette pervéance étant notamment fonction des variations dimensionnelles, d'origine thermique, de certains éléments constituant le canon électronique et également du vieillissement de la cathode. La compensation de ces variations de puissance nécessite donc une régulation de la haute tension, ce qui conduit à des dispositions relativement complexes peu appropriées à être mises en oeuvre avec les opérations de modulation de la puissance à fréquence élevée, qui sont souvent exigées dans les opérations de soudage par faisceau d'électrons.

Au contraire, le fonctionnement en régime "triode" permet d'obtenir par de simples modifications de la polarisation du Wehnelt une régulation aisée du courant de soudage, donc une puissance de soudage régulée à une valeur qui peut être constante. Cependant, les variations importantes de polarisation du Wehnelt s'accompagnent d'un déplacement du point de focalisation électrostatique et d'un accroissement de l'angle d'ouverture du faisceau électronique ce qui fait que, pour éviter un échauffement excessif de l'anode, on est amené à accroître substantiellement la conductance de celle-ci, en d'autres termes à accroître le diamètre du passage de traversée anodique, ce qui a un effet particulièrement néfaste sur le maintien du vide profond dans l'espace interélectrodes.

La présente invention s'applique aux opérations de soudage par faisceau électronique comportant une montée et une descente progressive de la puissance de soudage et a pour objet de pallier les inconvénients mentionnés en régime "diode" et en régime "triode" en utilisant une combinaison appropriée de ces deux procédés de régulation, qui permet de mettre en oeuvre essentiellement chaque fois leurs avantages, sans pour autant entraîner les inconvénients qui ont été mentionnés.

Selon l'invention, au cours d'un procédé de régulation d'un générateur de soudage par faisceau d'électrons du type à trois électrodes : cathode, Wehnelt et anode, selon lequel on agit sur la tension d'accélération entre cathode et anode, et/ou sur la tension de polarisation du Wehnelt, pour assurer une opération de soudage comprenant une phase initiale de montée progressive en puissance, une phase opératoire substantiellement en palier de puissance qui est assurée par un maintien substantiellement constant de la tension d'accélération, tout en régulant dans d'étroites limites la puissance par variation du courant de soudage obtenu exclusivement par variation du potentiel du Wehnelt et une phase terminale de descente progressive en puissance, on prévoit de mettre en oeuvre la combinaison des mesures suivantes:

a) le phase initiale comprend une première phase de montée en puissance par accroîssement simultané, depuis des valeurs nulles, de la tension d'accélération et du courant de soudage, en maintenant le Wehnelt au potentiel de la cathode, cette première phase étant suivie d'une seconde phase au cours de laquelle la tension d'accélération continue à croître progressivement jusqu'à sa tension de palier, tandis que le Wehnelt est progressivement polarisé négativement par rapport à la cathode pour maintenir le courant de soudage substantiellement constant.

b) la phase terminale de descente progressive en puissance comprend une première phase de descente en puissance par réduction progressive de la tension d'accélération et un maintien substantiellement constant du courant par réduction progressive de la polarisation du Wehnelt jusqu'au potentiel de la cathode, et une seconde phase de descente en puissance obtenue par réduction de la tension d'accélération et du courant de soudage jusqu'à une valeur nulle.

Selon un mode particulier de réalisation de l'invention, on assure les variations de tension d'accélération par un régulateur du type à induction alimentant une régulation par thyristors et on règle la tension de sortie dudit régulateur à induction à une valeur supérieure de 5 à 15% à la valeur de la tension requise en sortie de la régulation par thyristors.

De la sorte, l'essentiel de la montée en puissance, ou de la descente en puissance, est assuré exclusivement par accroissement de la tension d'accélération, donc en régime "diode", ce qui signifie que le faisceau électronique reste bien focalisé dans le passage de traversée d'anode avec un angle d'ouverture aussi réduit que possible, tandis que les variations de tension d'accélération et/ou courant de soudage en régime de palier sont assurées par des modifications faciles à mettre en oeuvre de la polarisation du Wehnelt, donc en régime "triode" et comme ces variations sont cantonnées dans des limites étroites, elles ne risquent pas de provoquer d'importants déplacements du point de convergence électrostatique du faisceau, en sorte qu'on peut conserver le passage d'anode pratiquement avec la dimension réduite convenable en régime "diode".

Selon l'invention, une installation de régulation d'un générateur de soudage par faisceau d'électrons destiné à mettre en oeuvre le procédé ci-dessus, du genre avec une alimentation comportant un pont redresseur à tension associée, en amont, à un régulateur par induction, est caractérisée en ce qu'on prévoit:

a) des moyens de commande du régulateur à induction asservis à un moyen de montée en tension selon une vitesse donnée réglable, des moyens de réglage et de régulation en tension maximale selon une valeur donnée réglable, et un moyen de descente en tension selon une vitesse donnée réglable asservissant le régulateur à induction.

b) un moyen d'alimentation du Wehnelt asservi à un dispositif d'asservissement comparant une valeur maximale affichée du courant de soudage à une valeur mesurée.

Un mode de réalisation de l'invention est maintenant décrit en référence aux dessins annexés dans lesquels:

—la figure 1 est une vue schématique d'une installation selon l'invention;

—la figure 2 représente un diagramme respectivement de la tension d'accélération $U_{THT}$, du courant de soudage I et de la puissance I x $U_{THT}$ délivrée par le canon en fonction du temps.

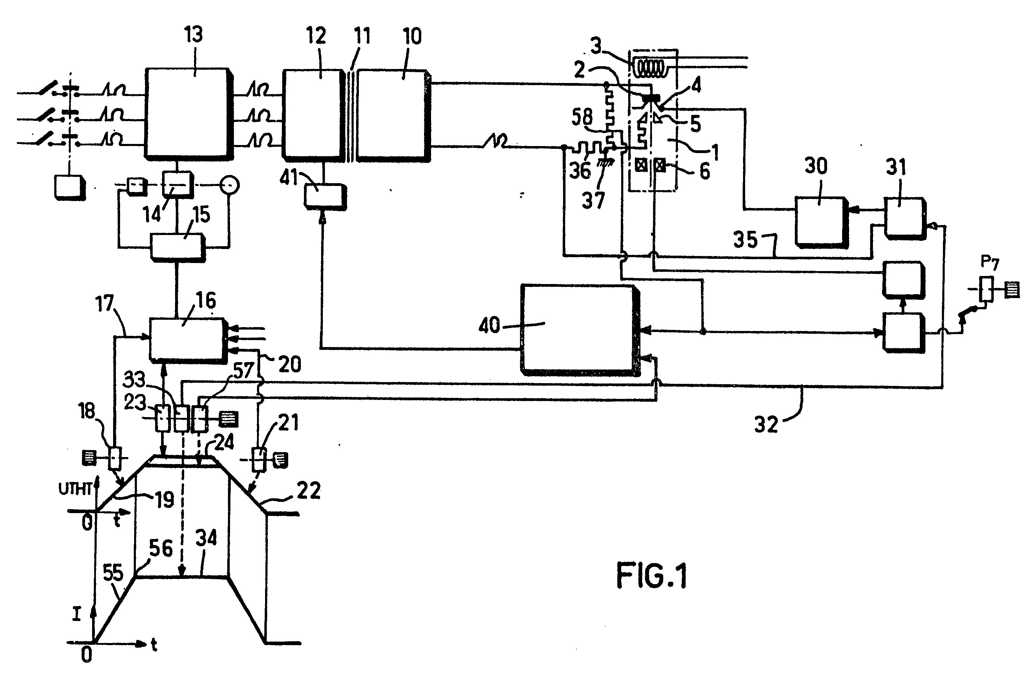

En se rérérant aux dessins annexés, on voit qu'un canon électronique 1 comprend essentiellement une cathode 2 chauffée par un filament 3, un Wehnelt 4 et une anode 5, ainsi qu'un enroulement de focalisation électromagnétique 6. La cathode 2 et l'anode 5 sont branchées aux bornes d'un circuit incorporant d'amont en aval un secondaire d'un transformateur 11, un pont redresseur et un moyen de filtrage, représentés sur la figure 1 par l'élément 10, l'ensemble 12 représente le primaire du transformateur 11 et le jeu de thyristors associés, qui eux-mêmes sont alimentés par un régulateur à induction 13. Le régulateur à induction 13 comporte de façon usuelle une partie tournante qui peut être mise en rotation par un moteur 14 alimenté par un amplificateur 15 à partir d'un dispositif de commande 16 ayant plusieurs entrées, dont l'une 17 incorpore un potentiomètre 18 de réglage de la pente de montée en tension selon une courbe 19, tandis qu'une autre entrée 20 incorpore un potentiomètre 21 de réglage de la pente de descente de la haute tension selon une courbe 22. Une troisième entrée 23 maintient la tension maximale en sortie du régulateur à induction au niveau indiqué en 24.

Le Wehnelt 4 est lui-même branché à une alimentation 30, qui est commandée par un dispositif d'asservissement 31 comparant, d'une part via un circuit 32 à potentiomètre 33, une tension de référence correspondant à la valeur affichée du courant maximal de soudage I indiqué en 34, d'autre part une tension mesurée par le circuit 35 aboutissant à une borne de résistance 36, parcourue par le courant de soudage et dont l'autre borne est connectée à la masse 37.

L'ensemble 40 comprend un dispositif qui réalise la comparaison entre la valeur de la très haute tension affichée par le potentiomètre 57 et la valeur mesurée en permanence par le pont diviseur 58 et qui commande les déclencheurs 41 des thyristors.

Le fonctionnement de l'installation décrite est le suivant:

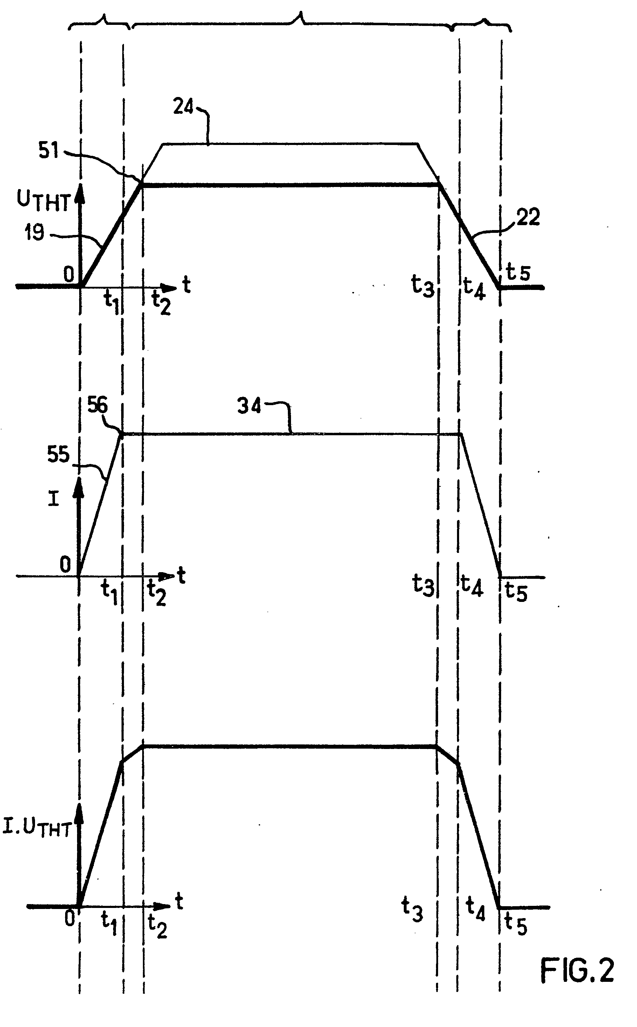

à partir d'une situation où la tension d'accélération et le courant de soudage sont nuls (on se référera également à la figure 2):

a) dans un premier temps, la tension d'accélération U THT s'accroît progressivement depuis la valeur O comme indiqué en 19 jusqu'au 51 par rotation qui représente le niveau de la tension à la sortie des thyristors. Pendant cette phase de montée en tension, le courant de soudage I débité par le canon part d'une valeur nulle pour augmenter progressivement comme indiqué par la courbe 55 jusqu'à un point 56, qui se situe à un temps t1 inférieur à un temps t2 correspondant au point 51 de la tension d'accélération $U_{THT}$. Pendant le laps de temps O—t1, la puissance du canon a été accrue linéairement avec une vive progression, tandis que dans le laps de temps t1—t2, cette même puissance a continué à progresser, mais à moins vive allure, puisque le courant de soudage I est maintenu à un niveau constant depuis le temps t1. Pendant toute cette période de temps t0 à t1, le fonctionnement du canon est du type "diode". Cela se traduit sur le schéma de la figure 1 par le fait que le moteur 14 est mis en rotation sous l'effet du dispositif de commande 16 selon une pente d'accroissement de tension de la courbe 19 qui est fixée par le potentiomètre 18. Pendant toute la période O—t1, le Wehnelt 4 est alimenté par l'alimentation de façon à être rigoureusement au même potentiel que la cathode 2.

A partir du temps t1, le dispositif d'alimentation de Wehnelt 30 commence à polariser négativement le Wehnelt 4 sous l'action du dispositif d'asservissement 31 qui compare le courant mesuré via le circuit 35 avec la valeur affichée de ce courant selon la courbe 55 réglée par le potentiomètre 33 et dont la valeur est transmise par le circuit 32, cette valeur étant constante fixée au niveau 34 dès le point 56 (temps t1) et jusqu'au point t4. C'est un fonctionnement de type "triode".

b) à partir du temps t2, la valeur de la haute tension reste constante grâce à régulation par thyristors, tandis que le régulateur par induction continue sa course jusqu'à une position telle que sa tension de sortie 24 soit en fonction de la tension supérieure de 5 à 15% à la tension requise en sortie de la régulation par thyristors.

Si pour diverses causes, comme par exemple de variations dimensionnelles d'origine thermique ou vieillissement de la cathode, le courant de soudage I a tendance à varier quelque peu par rapport à la valeur affichée, cette variation est compensée par une variation de potentiel du Wehnelt 4 assurée par la comparaison entre la valeur affichée par le circuit 32 et la valeur mesurée par le circuit 35. Mais de telles variations sont étroitement limitées et en tout cas ne dépassent jamais 15% des valeurs précédemment déterminées.

c) lorsque l'opération de soudage arrive à sa fin, le circuit de descente se met en rotation et le moteur 14 se met à tourner dans le sens inverse pour réduire la tension à la sortie du régulateur 13 sous l'action de commande du dispositif 16, lui-même asservi au potentiomètre de descente 21.

Pendant la première phase t3—t4, le courant de soudage est encore maintenu constant par une dépolarisation progressive du Wehnelt 4, et la chute de puissance suit une pente modérée, tandis que dans la phase suivante t4—t5, non seulement la tension d'accélération continue à chuter, mais également le courant de soudage commence également à se réduire. C'est en fait très exactement un déroulement inverse de celui qu'on a rencontré pendant le laps de temps 0—t2.

On rappelle que pendant le laps de temps 0—t1, et pendant le laps de temps t4—t5, la tension du Wehnelt est maintenue constante et égale à celle de la cathode 2 en sorte qu'on est en régime "diode".

Dans le laps de temps t2—t3, où la tension d'accélération est maintenue constante et où l'on règle en fonction du potentiel du Wehnelt, on se situe donc dans le fonctionnement en régime purement "triode".

Dans les laps t1—t2 et t3—t4, on se situe également dans une phase de régime "triode" puisque le potentiel de Wehnelt est modifié par rapport au potentiel de la cathode, mais en outre, on superpose à ce régime, un régime du type "diode" par modification de la tension d'accélération.

**Revendications**

1. Procédé de régulation d'un générateur de soudage par faisceau d'électrons du type à trois électrodes : cathode (2), Wehnelt (4) et anode (5), selon lequel on agit sur la tension d'accélération entre cathode (2) et anode (5) et/ou sur la tension de polarisation du Wehnelt (4), pour assurer une opération de soudage comprenant une phase initiale de montée progressive en puissance, une phase opératoire substantiellement en palier de puissance qui est assurée par un maintien substantiellement constant de la tension d'accélération tout en régulant dans d'étroites limites, la puissance par variation du courant de soudage obtenue exclusivement par variation du potentiel du Wehnelt (4) et une phase terminale de descente progressive en puissance, caractérisé par la combinaison des mesures suivantes:

a) la phase initiale comprend une première phase de montée en puissance par accroissement simultané depuis des valeurs nulles de la tension d'accélération et du courant de soudage, en maintenant le Wehnelt (4) au potentiel de la cathode (2), cette première phase étant suivie d'une seconde phase au cours de laquelle la tension d'accélération, continue à croître progressivement jusqu'à sa tension de palier, tandis que le Wehnelt (4) est progressivement polarisé négativement par rapport à la cathode (2) pour maintenir le courant de soudage substantiellement constant.

b) la phase terminale de descente progressive en puissance comprend une première phase de descente en puissance par réduction progressive de la tension d'accélération et un maintien substantiellement constant du courant par réduction progressive de la polarisation du Wehnelt (4) jusqu'au potentiel de la cathode (2), et une seconde phase de descente en puissance obtenue par réduction de la tension d'accélération jusqu'à une valeur nulle.

2. Procédé de régulation d'un générateur de soudage par faisceau d'électrons selon la revendication 1, caractérisé, en ce que l'on assure les variations de tension d'accélération par un régulateur du type à induction (13) alimentant une régulation par thyristors (12) et en ce qu'on règle la tension de sortie dudit régulateur à induction à une valeur (13) supérieure de 5 à 15% à la valeur de la tension requise en sortie de la régulation par thyristors.

3. Installations de régulation d'un générateur de soudage par faisceau d'électrons pour la mise en oeuvre du procédé selon la revendication 2 avec une alimentation comportant un pont redresseur à tension (10) associée, en amont, à un régulateur par induction (13), caractérisé en ce qu'on prévoit:

a) des moyens de commande (14, 15, 16) du régulateur à induction (13) asservis à un moyen de montée en tension (18) selon une vitesse donnée réglable, des moyens de réglage et de régulation en tension maximale (23 ; 40, 57, 58) selon une valeur donnée réglable, et un moyen de descente en tension (21) selon une vitesse donnée réglable asservissant le régulateur à induction (13).

b) un moyen d'alimentation du Wehnelt asservi à un dispositif d'asservissement comparant une valeur maximale affichée du courant de soudage à une valeur mesurée.

**Claims**

1. Method to regulate a welding generator by electron bundle having three electrodes: cathode (2), Wehnelt cylinder (4) and anode (5), whereby one acts on the acceleration tension between cathode (2) and anode (5) and/or on the polarization tension of the Wehnelt cylinder (4) to assure a welding operation comprising an initial phase with progressively ascending power, an operating phase with substantially horizontal power which is assured by maintaining substantially constant the acceleration tension by regulating the power in narrow limits by varying the welding current obtained exclusively by variation of the potential of Wehnelt cylinder (4), and a terminal phase of progressively descending power, characterized by the combination of the following measures:

a) the initial phase comprises a first phase of ascending power by simultaneous increase from zero values of the acceleration tension and of the welding current, by maintaining the Wehnelt cylinder (4) on a potential of the cathode (2), whereby this first phase is followed by a second phase in the cause of which the acceleration tension continues to increase progressively up to the horizontal tension, whereas the Wehnelt cylinder (4) is progressively negatively polarized with respect to the cathode (2) in order to maintain the welding current substantially constant.

b) the terminal phase of the progressively descending power comprises a first phase of descending power by progressive reduction of the acceleration tension and maintaining the current substantially constant by progressive reduction of the polarization of the Wehnelt cylinder (4) to the potential of the cathode (2), and a second phase of descending power obtained by reducing the acceleration tension to a zero value.

2. Method according to claim 1, characterized by that one assures the variations of the acceleration tension by an induction regulator (13) supplying a regulation by thyristors (12) and that one regulates the output tension of said induction regulator (13) to a value 5 to 15% higher than the value of the tension requested at the output, of the regulation by thyristors.

3. Installation to regulate a welding generator by electron bundle to perform the method according to claim 2, comprising a supply with a tension rectifier bridge (10) associated upstream to an induction regulator (13), characterized by:

a) control means (14, 15, 16) of the induction regulator (13) controlled to a means (18) for tension increase according to a given regulable speed, control means and means (23; 40, 57, 58) for maximal tension regulation according to a given regulable value and a means (21) for decreasing the tension according to a given regulable speed controlling the induction regulator (13),

b) supplying means for the Wehnelt cylinder controlled to a controlling device comparing a maximal nominal value of the welding current with a measured value.

## Patentansprüche

1. Verfahren zum Regulieren eines Schweißgenerators durch Elektronenbündel mit drei Elektroden: Einer Kathode (2), einem Wehneltzylinder (4) und einer Anode (5), bei welchem man auf die Beschleunigungsspannung zwischen Kathode (2) und Anode (5) und/oder auf die Polarisationsspannung des Wehneltzylinders (4) einwirkt, um einen Schweißbetrieb sicherzustellen mit einer ersten Anfangsphase mit zunehmendem Leistungsanstieg, einer Betriebsphase mit im wesentlichen horizontaler Leistung, die dadurch sichergestellt wird, daß man die Beschleunigungsspannung im wesentlichen konstant hält, indem man die Leistung durch Veränderung des Schweißstromes, der ausschließlich durch Veränderung des Potentials des Wehneltzylinders (4) erhalten ist, in engen Grenzen reguliert, und eine Endphase fortlaufend abnehmender Leistung, gekennzeichnet durch die Kombination folgender Maßnahmen:

a) Die Anfangsphase weist eine erste Leistungsanstiegsphase auf durch gleichzeitige Zunahme der Beschleunigungsspannung von Null-Werten an sowie des Schweißstromes, indem man den Wehneltzylinder (4) auf dem Potential der Kathode (2) hält, wobei diese erste Phase von einer zweiten Phase gefolgt wird, in deren Verlauf die Beschleunigungsspannung fortlaufend zunehmend bis zu einer horizontalen Spannung wächst, während der Wehneltzylinder (4) zunehmend bezüglich der Kathode (2) negativ polarisiert wird, um den Schweißstrom im wesentlichen konstant zu halten,

b) die Endphase der fortlaufenden Leistungsabnahme weist eine erste Phase mit abnehmender Leistung durch fortlaufende Verringerung der Beschleunigungsspannung sowie dadurch, daß man den Strom im wesentlichen durch zunehmende Verringerung der Polarisation des Wehneltzylinders (4) bis auf das Potential der Kathode (2) konstant hält, und eine zweite Phase mit Leistungsabfall auf, die man durch Verringerung der Beschleunigungsspannung bis auf einen Wert Null erhält.

2. Verfahren nach Anspruch 1, dadurch gekennzeichnet, daß man die Veränderungen der Beschleunigungsspannung durch einen Induktionsregulator (13) sicherstellt, der eine Steuerung durch Thyristoren (12) versorgt, und daß man die Ausgangsspannung dieses Induktionsregulators (13) auf einen Wert regelt, der um 5 bis 15% über dem Wert der erforderlichen Spannung liegt, und zwar am Ausgang der Steuerung durch Thyristoren.

3. Einrichtung zum Regulieren eines Schweißgenerators durch Elektronenbündel zur Durchführung des Verfahrens nach Anspruch 2 mit einer Versorgung mit einer Spannungsgleichrichterbrücke (10), die aufstromig mit einem Induktionsregulator (13) verbunden ist, gekennzeichnet durch

a) Steuermittel (14, 15, 16) des Induktionsregulators (13), die zu einem Mittel für den Spannungsanstieg (18) entsprechend einer gegebenen, regulierbaren Geschwindigkeit gesteuert werden, Mittel zum Regulieren und zum Regeln maximaler Spannung (23; 40, 57, 58) gemäß einem gegebenen, regulierbaren Wert und ein Mittel für den Spannungsabfall (21) gemäß einer gegebenen, regulierbaren Geschwindigkeit unter Steuerung des Induktionsregulators (13),

b) ein Mittel zur Versorgung des Wehneltzylinders, welches zu einer Steuervorrichtung gesteuert wird, unter Vergleich eines maximalen Schweißstromsollwertes mit einem gemessenen Wert.

FIG.1

FIG.2